# EUROPEAN PATENT APPLICATION

(11) **EP 4 517 838 A1**
(43) Date of publication of application: **05.03.2025**
(21) Application number: 24155122.5
(22) Date of filing: 31.01.2024
(51) Int. Cl.: H01L 31/0224, H01L 31/05

(54) **SOLAR CELL AND PHOTOVOLTAIC MODULE**

(30) Priority: 04.09.2023 CN 202311130532
(71) Applicant: Zhejiang Jinko Solar Co., Ltd., Haining, Zhejiang 314416 (CN)
(72) Inventor: TAO, Wusong, HAINING, 314416 (CN); FENG, Jun, HAINING, 314416 (CN); LUO, Heng, HAINING, 314416 (CN)
(74) Representative: DREISS Patentanwälte PartG mbB

(57) **Abstract**

The present disclosure relates to the technical field of photovoltaic modules, and in particular, to a solar cell and a photovoltaic module. The solar cell includes a substrate and a positive gate line and a negative gate line that are arranged on a back surface of the substrate, wherein the positive gate line and the negative gate line are alternately arranged and are not connected. An edge portion of at least one side of the back surface in at least one direction is an insulating portion overlap with one another overlap with one another.

## Description

### TECHNICAL FIELD

The present disclosure relates to the technical field of photovoltaic modules, and in particular, to a solar cell and a photovoltaic module.

### BACKGROUND

Solar cells have good photoelectric conversion capabilities. Therefore, the solar cells are the focus of development of clean energy. In order to ensure photoelectric conversion efficiency of the solar cells, research and development of the solar cells is ongoing. A full back-contact solar cell has good prospects because positive and negative metal electrodes are placed on a back surface of the solar cell and there is no gate line shielding a front surface of the solar cell, which can eliminate light-shielding current losses of the metal electrodes and maximize utilization of incident photons.

Nowadays, the full back-contact solar cell is formed by slicing in the middle and direct series soldering of electrode lines. The electrode lines are connected at intervals. The solar cells are stringed together and then are connected by busbars.

### SUMMARY

The present disclosure provides a solar cell and a photovoltaic module, intended to arrange an insulating portion on an edge portion of a back surface of the solar cell, such that edge portions of adjacent solar cells can overlap with one another, thereby increasing a quantity of solar cells that can be connected in solar cell strings and increasing an effective light-receiving area.

The present disclosure provides a solar cell, wherein the solar cell includes:
a substrate, a positive gate line and a negative gate line, and the positive gate line and the negative gate line are arranged on a back surface of the substrate, wherein the positive gate line and the negative gate line are alternately arranged and are not connected;
wherein an edge portion of at least one side of the back surface in at least one direction is an insulating portion.

In an embodiment, a width of the insulating portion ranges from 1.5 mm to 3 mm, and a thickness of the insulating portion ranges from 0.05 mm to 0.2 mm.

In an embodiment, the insulating portion is provided with a first insulating adhesive.

The present disclosure further provides a photovoltaic module, wherein the photovoltaic module includes: a solar cell string group, wherein the solar cell string group includes a plurality of solar cells, an edge portion of at least one side of a back surface of each of the solar cells in at least one direction is an insulating portion, the plurality of solar cells are connected to form solar cell strings, and a plurality of solar cell strings are connected to form the solar cell string group; in the solar cell string group, the edge portions of adjacent solar cells and/or adjacent solar cell strings in at least one direction are arranged in an overlapping manner.

In an embodiment, in the solar cell string group, along a first direction, there is a spacing between adjacent solar cells, and along a second direction, the edge portion of the at least one side of the back surface of the solar cell is an insulating portion, and edge portions of the adjacent solar cell strings overlap with one another.

In an embodiment, along the second direction, the outermost edge portion of the outermost solar cell is not the insulating portion.

In an embodiment, in the solar cell string group, along a first direction, the edge portion of the at least one side of the back surface of the solar cell is an insulating portion, and edge portions of the adjacent solar cells overlap with one another, and along a second direction, there is a spacing between adjacent solar cell strings.

In an embodiment, along the first direction, the outermost edge portion of the outermost solar cell is not the insulating portion.

In an embodiment, in the solar cell string group, along a first direction, the edge portion of the at least one side of the back surface of the solar cell is an insulating portion, and edge portions of the adjacent solar cells overlap with one another, and along a second direction, the edge portion of the at least one side of the back surface of the solar cell is an insulating portion, and edge portions of the adjacent solar cell strings overlap with one another.

In an embodiment, along the first direction and the second direction, the outermost edge portion of the outermost solar cell is not the insulating portion.

In an embodiment, an overlapping size of adjacent solar cells ranges from 0.1 mm to 1.5 mm.

In an embodiment, an overlapping size of adjacent solar cell strings ranges from 0.1 mm to 1.5 mm.

In an embodiment, adjacent solar cells are connected by electrode lines, and the electrode line required to pass through a positive gate line and a negative gate line are coated with a third insulating adhesive; and adjacent solar cell strings are connected by busbars.

In the present disclosure, the edge portion of the back surface of the solar cell in at least one direction is provided as the insulating portion, such that, when a plurality of solar cells are connected to form solar cell strings, the edge portions of adjacent solar cells can overlap with one another, thereby increasing a quantity of solar cells that can be connected in the solar cell strings and increasing an effective light-receiving area of the solar cell strings. When a plurality of solar cell strings are connected to form solar cell string groups, edge portions of adjacent solar cell string groups can overlap with one another, thereby increasing a quantity of solar cells that can be connected in the solar cell string groups, increasing an effective light-receiving area of the solar cell string groups, increasing generated power of the photovoltaic module, and reducing system costs other than the photovoltaic module.

It should be understood that the general description above and the detailed description in the following are merely exemplary and illustrative, and cannot limit the present disclosure.

### BRIEF DESCRIPTION OF DRAWINGS

FIG. 1 is a schematic structural diagram of a solar cell according to the present disclosure;
FIG. 2 is a schematic structural diagram of a solar cell string according to the present disclosure;
FIG. 3 is a schematic structural diagram of the solar cell string according to of the present disclosure in some embodiments;
FIG. 4 is a schematic structural diagram of a solar cell string group according to the present disclosure;
FIG. 5 is a schematic structural diagram of the solar cell string group according to of the present disclosure in some embodiments; and
FIG. 6 is a schematic diagram of stacking of solar cells according to the present disclosure.

### Reference signs:

1: solar cell;
   11: back surface;
   111: first busbar;
   112: second busbar;
   113: first finger;
   114: second finger;
   115: insulating portion;
   116: first pad;
   117: second pad;
   118: first electrode line;
   119: second electrode line;
2: solar cell string;
3: solar cell string group

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better understand the technical solutions of the present disclosure, embodiments of the present disclosure will be described in detail below in conjunction with the accompanying drawings.

It should be clear that the described embodiments are only some rather than all of the embodiments of the present disclosure. Based on the embodiments in the present disclosure, all other embodiments obtained by those of ordinary skill in the art without creative efforts fall within the protection scope of the present disclosure.

Terms used in the embodiments of the present disclosure are only for the purpose of describing specific embodiments, and are not intended to limit the present disclosure. Singular forms of "a/an", "the", and "said" used in the embodiments of the present disclosure and the appended claims are intended to include plural forms, unless otherwise clearly specified in the context.

It should be understood that the term "and/or" used herein describes an association relationship between associated objects and represents that three relationships may exist. For example, A and/or B may represent the following three cases: only A exists, both A and B exist, and only B exists. In addition, the character "/" herein generally indicates an "or" relationship between the associated objects.

It is to be noted that orientation terms such as "up", "down", "left", and "right" described in the embodiments of the present disclosure are described from the perspective shown in the accompanying drawings, and should not be construed as limiting the embodiments of the present disclosure. Besides, in this context, it is to be further understood that one element described as being connected "on" or "under" another element not only means that the element may be directly connected "on" or "under" the another element, but also means that the element may be indirectly connected "on" or "under" the another element through an intermediate element.

A full back-contact solar cell means that positive and negative metal contacts of the solar cell are moved to a back surface of the solar cell. There is no gate line on a front surface of the solar cell, which greatly increases a light-receiving area of the solar cell, thereby improving efficiency of the solar cell. However, in the full back-contact solar cell, there are connection gaps between solar cells and between solar cell strings, which reduces an overall effective area of the module, reduces generated power of the module, and increases investment costs.

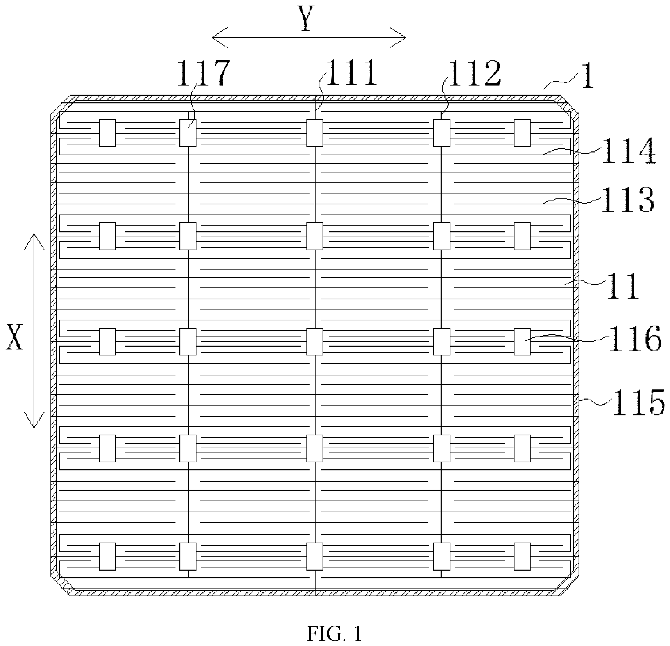

FIG. 1 shows a solar cell 1 according to the present disclosure. The solar cell 1 may be a full back-contact solar cell. Positive and negative metal electrodes are arranged on a back surface 11 of the solar cell, and there is no gate line shielding a front surface of the solar cell, which can eliminate light-shielding current losses of the metal electrodes. The solar cell 1 includes a substrate and a positive gate line and a negative gate line that are arranged on a back surface 11 of the substrate, wherein the positive gate line and the negative gate line are alternately arranged and are not connected. The positive gate line includes a first busbar 111 and a first finger 113, and the negative gate line includes a second busbar 112 and a second finger 114. Along a second direction Y, the first busbar 111 and the second busbar 112 are alternately arranged, and the first busbar 111 and the second busbar 112 extend along a first direction X. Along the first direction X, the first finger 113 and the second finger 114 are alternately arranged, and the first finger 113 and the second finger 114 extend along the second direction Y. Along the second direction Y, the first finger 113 is connected to the first busbar 111 and is not connected to the second busbar 112 adjacent thereto, and the second finger 114 is connected to the second busbar 112 and is not connected to the first busbar 111 adjacent thereto. The solar cell 1 further includes a plurality of first pads 116 and second pads 117 arranged on the back surface 11 of the substrate. The first pads 116 are distributed at a connection position of the first busbar 111 and the first finger 113, an extension line of the first busbar 111, and an extension line of the first finger 113, and the first pads 116 are not connected to the second busbar 112 and the second finger 114. The second pads 117 are distributed at a connection position of the second busbar 112 and the second finger 114, an extension line of the second busbar 112, and an extension line of the second finger 114, and the second pads 117 are not connected to the first busbar 111 and the first finger 113.

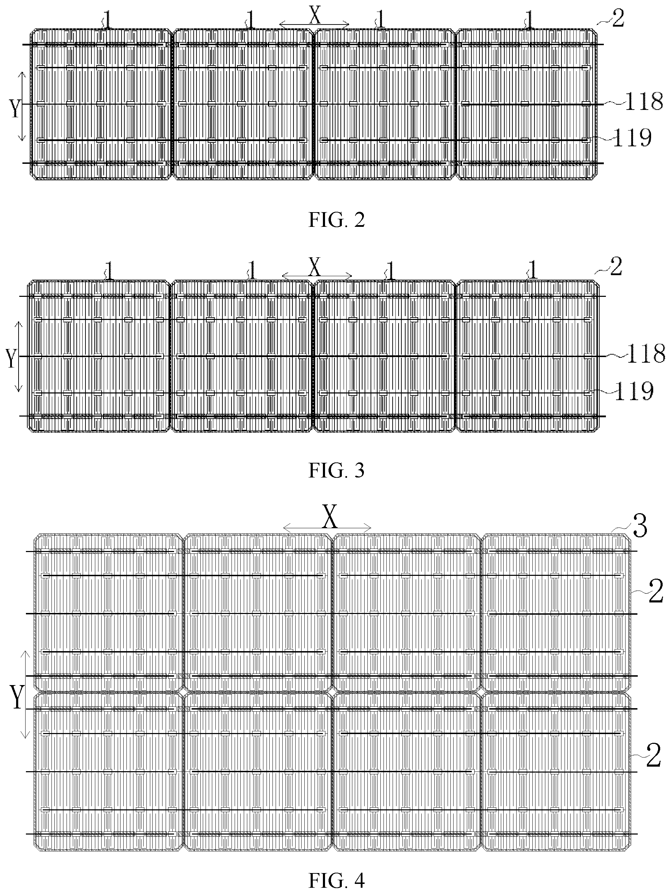

In this embodiment, an edge portion of at least one side of the back surface 11 in at least one direction is an insulating portion 115. As shown in FIG. 2 and FIG. 3, the insulating portion 115 is arranged on the edge portion of the back surface 11 of the solar cell 1, such that, when a plurality of solar cells 1 are connected to form solar cell strings 2, the edge portions of adjacent solar cells 1 can overlap with one another, thereby increasing a quantity of solar cells 1 that can be connected in the solar cell strings 2 and increasing an effective light-receiving area. Since the edge portion is provided as the insulating portion 115, when the back surface 11 of one solar cell 1 is in contact with the front surface of another adjacent solar cell 1, contact of gate lines of the edge portion with the front surface of the solar cell 1 can be prevented, thereby preventing a short circuit.

Similarly, as shown in FIG. 4 to FIG. 6, when the plurality of solar cells 1 are connected to form solar cell strings 2, edge portions of adjacent solar cell strings 2 can overlap with one another, thereby further increasing the quantity of solar cells 1 that can be connected in a unit module, further increasing the effective light-receiving area, achieving output of higher generated power by the module, and reducing costs. Since the edge portion is provided as the insulating portion 115, when the back surface 11 of one solar cell string 2 is in contact with the front surface of another adjacent solar cell string 2, contact of gate lines of the edge portion of the solar cell 1 with the front surface of the solar cell string 2 can be prevented, thereby preventing a short circuit.

For example, in the solar cell 1, the edge portion of at least one side of the back surface 11 in at least one direction may be provided as the insulating portion 115 according to an operation requirement. For example, along the first direction X, the edge portion of the solar cell 1 is the insulating portion 115, and along the second direction Y, the edge portion of the solar cell 1 is the insulating portion 115, such that, when the solar cells 1 are connected, the edge portions of adjacent solar cells 1 overlap with one another. When the solar cell strings 2 formed by connecting the solar cells 1 are connected, the edge portions of adjacent solar cell strings 2 overlap with one another. Alternatively, along the first direction X, the edge portion of the solar cell 1 is the insulating portion 115, and along the second direction Y, the edge portion of the solar cell 1 is not the insulating portion 115, such that, when the solar cells 1 are connected, the edge portions of adjacent solar cells 1 overlap with one another. When the solar cell strings 2 formed by connecting the solar cells 1 are connected, there is a spacing between the edge portions of adjacent solar cell strings 2. Alternatively, along the first direction X, the edge portion of the solar cell 1 is not the insulating portion 115, and along the second direction Y, the edge portion of the solar cell 1 is the insulating portion 115, such that, when the solar cells 1 are connected, there is a spacing between the edge portions of adjacent solar cells 1. When the solar cell strings 2 formed by connecting the solar cells 1 are connected, the edge portions of adjacent solar cell strings 2 overlap with one another.

In the above embodiments where the edge portions are arranged in an overlapping manner, the edge portion of at least one side of the solar cell 1 is provided as the insulating portion 115. For example, along the first direction X, when the edge portions of adj acent solar cells 1 are arranged in an overlapping manner, the edge portion at one end of the solar cell 1 is the insulating portion 115, and the edge portion at the other end is not the insulating portion 115. In an example where the adjacent solar cells 1 are a first solar cell and a second solar cell respectively, when a front edge portion of the first solar cell overlaps with an edge portion of the back surface 11 of the second solar cell, the edge portion of the back surface 11 directly facing the front surface of the first solar cell may not be provided as the insulating portion 115, which saves costs.

Alternatively, along the second direction Y, when the edge portions of adjacent solar cell strings 2 are arranged in an overlapping manner, the edge portion at one end of the solar cell 1 is the insulating portion 115, and the edge portion at the other end is not the insulating portion 115. In an example where the adjacent solar cell strings 2 are a first solar cell string and a second solar cell string respectively, when a front edge portion of the first solar cell string overlaps with an edge of the back surface 11 of the second solar cell string, the edge portion of the back surface 11 directly facing the front surface of the first solar cell string may not be provided as the insulating portion 115, which saves costs.

In the above embodiments, as shown in FIG. 3, in the solar cell string 2, along the first direction X and/or along the second direction Y, outermost edge portions of two outermost solar cells 1 do not overlap with other components and may not be provided as the insulating portion 115.

In some embodiments, the solar cell is provided with insulating adhesive, and the insulating adhesive includes a first insulating adhesive, a second adhesive and a third adhesive, and the insulating portion is provided with first insulating adhesive, and the first insulating adhesive may be epoxy resin, polyurethane resin, acrylic resin, or the like. The first insulating adhesive may be the same as the second insulating adhesive printed on a gate line of the solar cell 1. For example, the first insulating adhesive on the edge portion has a same height and composition as the second insulating adhesive on the gate line. Alternatively, the first insulating adhesive may not be the same as the second insulating adhesive printed on the gate line of the solar cell 1. For example, a height of the first insulating adhesive on the edge portion is lower than that of the second insulating adhesive on the gate line, and composition of the first insulating adhesive on the edge portion is different from that of the second insulating adhesive on the gate line. The first insulating adhesive on the edge portion and the second insulating adhesive on the gate line may be printed simultaneously or separately. The first insulating adhesive is provided on the edge portion of the back surface 11 of the solar cell 1 to enable the edge portion to bring an insulating effect and to prevent a short circuit caused by contact of the gate line on the edge portion with the front surfaces of other solar cells 1.

A width of the insulating portion ranges from 1.5 mm to 3 mm, and a thickness of the insulating portion 115 ranges from 0.05 mm to 0.2 mm. That is, the width of the insulating portion provided on the edge portion of the solar cell 1 may range from 1.5 mm to 3 mm, such as 1.5 mm, 2 mm, 2.5 mm, or 3 mm. The thickness of the insulating portion provided on the edge portion of the solar cell 1 may range from 0.05 mm to 0.2 mm, such as 0.05 mm, 0.1 mm, 0.15 mm, or 0.2 mm.

The width of the insulating portion should not be excessively large or excessively small. If the width of the insulating adhesive is excessively large (e.g., greater than 3 mm), an amount of the insulating adhesive is increased, and the cost and a weight of the solar cell 1 are increased. If the width of the insulating adhesive is excessively small (e.g., less than 1.5 mm), the edge portion of the solar cell 1 has a small insulating area, and after the solar cells 1 are connected, the back surface 11 of the solar cell 1 may be in direct contact with the front surface of the adjacent solar cell 1, and a short circuit may occur.

The thickness of the insulating portion should not be excessively large or excessively small. If the thickness of the insulating adhesive is excessively large (e.g., greater than 0.2 mm), an amount of the insulating adhesive is increased, resulting in an increase in a height of a connection position between adjacent solar cells 1 after overlapping, the adjacent solar cells 1 produce stress concentration at an overlapping position thereof, and there is a risk of damages to the solar cells 1 under the action of pressure. If the thickness of the insulating adhesive is excessively small (e.g., less than 0.05 mm), the thickness of the insulating adhesive applied to the edge portion of the solar cell 1 is relatively thin, which may result in that the insulating adhesive does not completely cover the gate line provided on the edge portion of the solar cell 1, and there is a risk of a short circuit after the solar cells 1 are connected. Therefore, when the width of insulating portion ranges from 1.5 mm to 3 mm and the thickness of the insulating portion ranges from 0.05 mm to 0.2 mm, stable operation of the solar cells 1 after connection can be ensured.

In some other embodiments, the solar cell 1 may alternatively be a double-sided light-receiving solar cell. That is, the front surface and the back surface 11 of the solar cell 1 are provided with gate lines. The edge portions on the front surface and the back surface 11 of the solar cell 1 may be provided as insulating portions 115, to prevent contact of positive gate lines with negative gate lines.

FIG. 1 to FIG. 6 further show a photovoltaic module. The photovoltaic module includes a solar cell string group 3. The solar cell string group 3 includes a plurality of solar cells 1. The solar cells 1 may be full back-contact solar cells. An edge portion of at least one side of a back surface 11 of the solar cell 1 in at least one direction is an insulating portion 115, and the plurality of solar cells 1 are connected to form solar cell strings 2. A plurality of solar cell strings 2 are connected to form a solar cell string group 3. In the solar cell string group 3, edge portions of adjacent solar cells 1 and/or adjacent solar cell strings 2 in at least one direction are arranged in an overlapping manner.

In this embodiment, the edge portion of the back surface 11 of the solar cell 1 in at least one direction is provided as the insulating portion 115, such that, when a plurality of solar cells 1 are connected to form solar cell strings 2, the edge portions of adjacent solar cells 1 can overlap with one another, thereby increasing a quantity of solar cells 1 that can be connected in the solar cell strings 2 and increasing an effective light-receiving area of the solar cell strings 2. When a plurality of solar cell strings 2 are connected to form solar cell string groups 3, edge portions of adjacent solar cell strings 2 can overlap with one another, thereby increasing a quantity of solar cells 1 that can be connected in the solar cell string groups 3, increasing an effective light-receiving area of the solar cell string groups 3, increasing generated power of the photovoltaic module, and reducing system costs (mainly composed of main equipment such as a light inverter, a bracket, cables, costs, as well as civil engineering, installation engineering, project design, project acceptance, and preliminary related expenses) other than the photovoltaic module.

For example, in the solar cell string group 3, along the first direction X, there is a spacing between adjacent solar cells 1, and along the second direction Y, the edge portion of at least one side of the back surface 11 of the solar cell 1 is the insulating portion 115, and edge portions of adjacent solar cell strings 2 overlap with one another.

In this embodiment, along the first direction X, the edge portion of the solar cell 1 is not the insulating portion 115, and along the second direction Y, the edge portion of the solar cell 1 is the insulating portion 115. After the solar cells 1 are connected to form the solar cell string group 3, along the first direction X, a spacing is required between adjacent solar cells 1, preventing a short circuit after the solar cells 1 are connected. Along the second direction Y, edge portions of adjacent solar cell strings 2 may overlap with one another.

Along the second direction Y, the edge portion of at least one side of the back surface 11 of the solar cell 1 is the insulating portion 115. That is, along the second direction Y, edge portions at two ends of the solar cell 1 may both be the insulating portion 115. Alternatively, along the second direction Y, the edge portion at one end of the solar cell 1 may be the insulating portion 115, and the edge portion at the other end of the solar cell 1 may not be the insulating portion 115. In an example where the adjacent solar cell strings 2 are a first solar cell string and a second solar cell string, when a front edge portion of the first solar cell string overlaps with an edge portion of the back surface 11 of the second solar cell string, the edge portion of the back surface 11 directly facing the front surface of the first solar cell string may not be provided as the insulating portion 115, and the first solar cell string and the second solar cell string are insulated and connected through the insulating portion 115 on the second solar cell string, which saves costs.

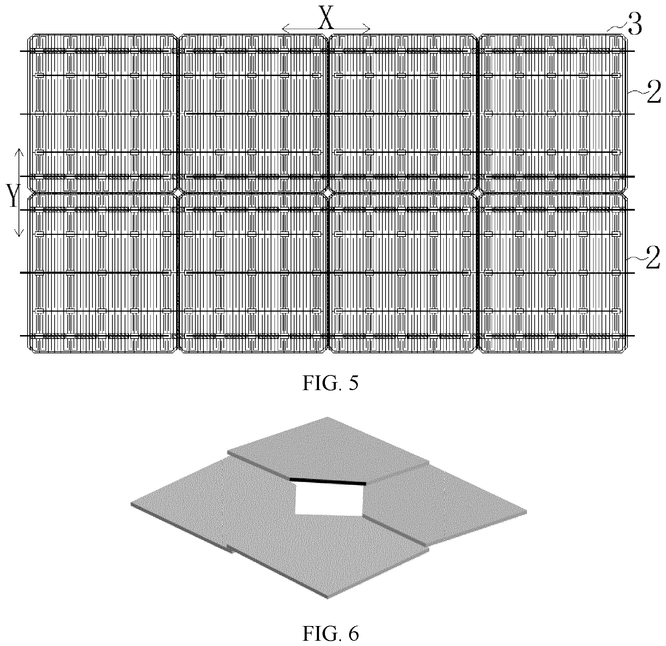

FIG. 3 and FIG. 5 show the solar cell string group 3, and in the solar cell string group 3, along the second direction Y, outermost edge portions of two outermost solar cells 1 may not be provided as the insulating portion 115.

In some embodiments, in the solar cell string group 3, along the first direction X, the edge portion of at least one side of the back surface 11 of the solar cell 1 is the insulating portion 115, and edge portions of adjacent solar cells 1 overlap with one another, and along the second direction Y, there is a spacing between adjacent solar cell strings 2.

In this embodiment, along the first direction X, the edge portion of the solar cell 1 is the insulating portion 115, and along the second direction Y, the edge portion of the solar cell 1 is not the insulating portion 115. After the solar cells 1 are connected to form the solar cell string group 3, along the first direction X, edges of adjacent solar cells 1 may be arranged in an overlapping manner. Along the second direction Y, a spacing is required between adjacent solar cell strings 2, preventing a short circuit after the solar cell strings 2 are connected.

Along the first direction X, the edge portion of at least one side of the back surface 11 of the solar cell 1 is the insulating portion 115. That is, along the first direction X, edge portions at two ends of the solar cell 1 may both be the insulating portion 115. Alternatively, along the first direction X, the edge portion at one end of the solar cell 1 may be the insulating portion 115, and the edge portion at the other end of the solar cell 1 may not be the insulating portion 115. In an example where the adjacent solar cells 1 are a first solar cell and a second solar cell, when a front edge portion of the first solar cell overlaps with an edge portion of the back surface 11 of the second solar cell, the edge portion of the back surface 11 directly facing the front surface of the first solar cell may not be provided as the insulating portion 115, and the first solar cell and the second solar cell are insulated and connected through the insulating portion 115 on the second solar cell, which saves costs.

Moreover, in FIG. 3 and FIG. 5, in the solar cell string group 3, along the first direction X, outermost edge portions of two outermost solar cells 1 may not be provided as the insulating portion 115.

In some embodiments, in the solar cell string group 3, along the first direction X, the edge portion of at least one side of the back surface 11 of the solar cell 1 is the insulating portion 115, and edge portions of adjacent solar cells 1 overlap with one another, and along the second direction Y, the edge portion of at least one side of the back surface 11 of the solar cell 1 is the insulating portion 115, and edge portions of adjacent solar cell strings 2 overlap with one another.

In this embodiment, along the first direction X, the edge portion of the solar cell 1 is the insulating portion 115, and along the second direction Y, the edge portion of the solar cell 1 is also the insulating portion 115. After the solar cells 1 are connected to form the solar cell string group 3, along the first direction X, the edge portions between adjacent solar cells 1 may be arranged in an overlapping manner, and along the second direction Y, the edge portions of adjacent solar cell strings 2 may be arranged in an overlapping manner.

Along the first direction X, the edge portion of at least one side of the back surface 11 of the solar cell 1 is the insulating portion 115. That is, along the first direction X, edge portions at two ends of the solar cell 1 are both the insulating portion 115. Alternatively, along the first direction X, the edge portion at one end of the solar cell 1 may be the insulating portion 115, and the edge portion at the other end of the solar cell may not be the insulating portion 115. In an example where the adjacent solar cells 1 are a first solar cell and a second solar cell, when a front edge portion of the first solar cell overlaps with an edge portion of the back surface 11 of the second solar cell, the edge portion of the back surface 11 directly facing the front surface of the first solar cell may not be provided as the insulating portion 115, and the first solar cell and the second solar cell are insulated and connected through the insulating portion 115 on the second solar cell, which saves costs. Moreover, as shown in FIG. 3 and FIG. 5, in the solar cell string group 3, along the first direction X, outermost edge portions of two outermost solar cells 1 may not be provided as the insulating portion 115.

Similarly, along the second direction Y, the edge portion of at least one side of the back surface 11 of the solar cell 1 is the insulating portion 115. That is, along the second direction Y, edge portions at two ends of the solar cell 1 are both the insulating portion 115. Alternatively, along the second direction Y, the edge portion at one end of the solar cell 1 may be the insulating portion 115, and the edge portion at the other end of the solar cell 1 may not be the insulating portion 115. In an example where the adjacent solar cell strings 2 are a first solar cell string and a second solar cell string, the edge portion of the back surface 11 directly facing the front surface of the first solar cell string may not be provided as the insulating portion 115, and the first solar cell string and the second solar cell string are insulated and connected through the insulating portion 115 on the second solar cell string, which saves costs. Moreover, as shown in FIG. 3 and FIG. 5, in the solar cell string group 3, along the second direction Y, outermost edge portions of two outermost solar cells 1 may not be provided as the insulating portion 115.

In this embodiment, a gapless photovoltaic module is formed, which, compared with a conventional photovoltaic module, has improved characteristics such as anti-fading and reduced hot spot effects, achieves more power generation under same power and a same environment, and further reduces system power generation costs.

In some embodiments, an overlapping size of adjacent solar cells 1 ranges from 0.1 mm to 1.5 mm. In this embodiment, a connection spacing between a conventional solar cell and the solar cell 1 ranging from 0.8 mm to 1.5 mm is set to that an overlapping part between the solar cells 1 ranging from 0.1 mm to 1.5 mm, which increases a quantity of solar cells 1 provided in a single solar cell string 2, and changes a spacing between conventional adjacent solar cells 1 into an effective light-receiving area, such that energy output per unit area of the solar cell string 2 is higher.

The overlapping size of adjacent solar cells 1 may be 0.1 mm, 0.5 mm, 1.0 mm, 1.5 mm, or the like. The overlapping size should not be excessively large or excessively small. If the overlapping size is excessively large (e.g., greater than 1.5 mm), a contact area between the back surface 11 of one solar cell 1 and the front surface of a solar cell 1 adjacent thereto is excessively large, which shields more of a front area of the solar cell 1 and reduces the effective light-receiving area of the solar cell 1. If the overlapping size is excessively small (e.g., less than 0.1 mm), a contact area between the back surface 11 of one solar cell 1 and the front surface of a solar cell 1 adjacent thereto is small, and there is a risk of a spacing a short-circuit connection between two solar cells caused by shaking of the solar cell string group 3 prior to packaging.

An overlapping size of adjacent solar cell strings 2 ranges from 0.1 mm to 1.5 mm. In this embodiment, a connection spacing between the conventional solar cell string and the solar cell string 2 ranging from 0.4 mm to 3.9 mm is set to that an overlapping part between the solar cell strings 2 ranging from 0.1 mm to 1.5 mm, which increases a quantity of solar cell strings 2 provided in a unit photovoltaic module, and changes a spacing between conventional adjacent solar cell strings 2 into an effective light-receiving area, such that the photovoltaic module outputs higher generated power.

The overlapping size of adjacent solar cell strings 2 may be 0.1 mm, 0.5 mm, 1.0 mm, 1.5 mm, or the like. The overlapping size should not be excessively large or excessively small. If the overlapping size is excessively large (e.g., greater than 1.5 mm), a contact area between the back surface 11 of one solar cell string 2 and the front surface of a solar cell string 2 adjacent thereto is excessively large, which shields more of a front area of the solar cell string 2 and reduces the effective light-receiving area of the solar cell string 2. If the overlapping size is excessively small (e.g., less than 0.1 mm), a contact area between the back surface 11 of one solar cell string 2 and the front surface of a solar cell string 2 adjacent thereto is small, and there is a risk of a spacing a short-circuit connection between two solar cells caused by shaking of the solar cell string group 3 prior to packaging.

In some embodiments, adjacent solar cells 1 are connected by electrode lines, and the electrode line required to pass through a positive gate line and a negative gate line are coated with third insulating adhesive; and adjacent solar cell strings 2 are connected by busbars (not shown in the figure).

FIG. 1 to FIG. 3 show that the electrode line includes a first electrode line 118 and a second electrode line 119, and the first electrode line 118 is connected to a plurality of first pads 116, so as to realize extension of the first electrode line 118, such that the first electrode line 118 is connected to the solar cell 1 adjacent thereto. The second electrode line 119 is connected to a plurality of second pads 117, so as to realize extension of the second electrode line 119, such that the second electrode line 119 is connected to the solar cell 1 adjacent thereto. The first electrode line 118 passes through the positive gate line and the negative gate line in the extension, and the insulating adhesive is provided between the connected first pads 116 such that the first electrode line 118 is in indirect contact with the positive gate line and the negative gate line, so as to prevent the connection between the positive gate line and the negative gate line through the first electrode line 118.

The above descriptions are only preferred embodiments of the present disclosure, and are not intended to limit the present disclosure. For those skilled in the art, various modifications and changes may be made to the present disclosure. Any modifications, equivalent replacements, improvements, and the like made within the spirit and the principle of the present disclosure shall fall within the protection scope of the present disclosure.

## Claims

1. A solar cell, comprising:
a sub strate;
a positive gate line; and
a negative gate line,
wherein the positive gate line and the negative gate line are arranged on a back surface of the sub strate,
wherein the positive gate line and the negative gate line are alternately arranged and are not connected to each other; and
wherein an edge portion of at least one side of the back surface in at least one direction is an insulating portion.

2. The solar cell according to claim 1, wherein
a width of the insulating portion ranges from 1.5 mm to 3 mm, and a thickness of the insulating portion ranges from 0.05 mm to 0.2 mm.

3. The solar cell according to claim 2, wherein
the width of the insulating portion ranges from 2 mm to 2.5 mm, and a thickness of the insulating portion ranges from 0.1 mm to 0.15 mm.

4. The solar cell according to any one of claims 1-3, wherein
the insulating portion is provided with a first insulating adhesive.

5. The solar cell according to claim4, wherein
the first insulating adhesive is selected from epoxy resin, polyurethane resin, or acrylic resin.

6. A photovoltaic module, comprising:
a solar cell string group, wherein the solar cell string group comprises solar cells, an edge portion of at least one side of a back surface of each of the solar cells in at least one direction is an insulating portion, the solar cells are connected to form solar cell strings, and solar cell strings are connected to form the solar cell string group;
wherein, in the solar cell string group, edge portions of adjacent solar cells and/or adjacent solar cell strings in at least one direction are arranged in an overlapping manner.

7. The photovoltaic module according to claim 6, wherein,
in the solar cell string group, along a first direction, there is a spacing between adjacent solar cells, and along a second direction, the edge portion of the at least one side of the back surface of the solar cell is an insulating portion, and edge portions of the adjacent solar cell strings overlap with one another.

8. The photovoltaic module according to claim 7, wherein,
along the second direction, an outermost edge portion of an outermost solar cell is not the insulating portion.

9. The photovoltaic module according to claim 6, wherein, in the solar cell string group, along a first direction, the edge portion of the at least one side of the back surface of the solar cell is an insulating portion, and edge portions of adjacent solar cells overlap with one another, and along a second direction, a spacing is provided between adjacent solar cell strings.

10. The photovoltaic module according to claim 9, wherein,
along the first direction, an outermost edge portion of an outermost solar cell is not the insulating portion.

11. The photovoltaic module according to claim 6, wherein, in the solar cell string group, along a first direction, the edge portion of the at least one side of the back surface of the solar cell is an insulating portion, and edge portions of adjacent solar cells overlap with one another, and along a second direction, the edge portion of the at least one side of the back surface of the solar cell is an insulating portion, and edge portions of adjacent solar cell strings overlap with one another.

12. The photovoltaic module according to claim 11, wherein, along the first direction and the second direction, an outermost edge portion of an outermost solar cell is not the insulating portion.

13. The photovoltaic module according to any one of claims 9-12, wherein an overlapping size of adjacent solar cells ranges from 0.1 mm to 1.5 mm.

14. The photovoltaic module according to any one of claims 7-8 or 11-12, wherein an overlapping size of adjacent solar cell strings ranges from 0.1 mm to 1.5 mm.

15. The photovoltaic module according to any one of claims 6-14, wherein
adjacent solar cells are connected by electrode lines, and each of the electrode lines that passes through a positive gate line and a negative gate line is coated with a third insulating adhesive; and adjacent solar cell strings are connected by busbars.
